# EUROPEAN PATENT SPECIFICATION

(11) **EP 0 620 584 B1**
(45) Date of publication and mention of the grant of the patent: **02.01.1997**
(21) Application number: 94105574.1
(22) Date of filing: 11.04.1994
(51) Int. Cl.: H01L 21/00

(54) **Apparatus and method for providing consistent, non-jamming registration of notched semiconductor wafers**
Verfahren und Vorrichtung zur reproduzierbaren klemmfreien Ausrichtung von gekerbten Halbleiter-Scheiben
Appareil et méthode pour la mise en coincidence reproductible sans coincement d'une galette semi-conductrice à encoche

(30) Priority: 12.04.1993 US 46053
(43) Date of publication of application: 19.10.1994
(73) Proprietor: Hughes Aircraft Company, Los Angeles, California 90080-0028 (US)
(72) Inventor: Vollaro, Joseph F., Pleasantville, New York 10570 (US)
(74) Representative: KUHNEN, WACKER & PARTNER

(56) References cited:
- US-A- 4 820 930
- US-A- 4 887 904
- US-A- 5 180 150

## Description

### BACKGROUND OF THE INVENTION

### Field of the Invention

The present invention relates to the registration of semiconductor wafers undergoing multiple sequential processes, such as a metrology step followed by a thinning and/or etching processes and, in particular, relates to an apparatus that provides consistent, non-jamming registration of notched semiconductor wafers in order to correlate the registration of the semiconductor wafers throughout the multiple sequential processes.

### Description of the Prior Art

US-A-4 820 930 discloses a positioning device for positioning a mask having formed thereon a pattern to be transferred onto a semiconductor wafer. On the basis of a peripheral shape of the mask, the positioning device positions the mask so that a center of the mask is brought into alignment with a center of rotation of a holder for holding the mask. The positioning device includes a plurality of engaging pins to be engaged by the periphery of the marks, each engaging pin being movable in a direction towared the center of rotation of the mask holder. Movement of each of the engaging pins is controlled independently from the others, whereby the mask can be positioned irrespective of its size and/or shape.

The process of measuring the thickness of an outer material layer of a semiconductor wafer is known as wafer surface metrology. During such a wafer surface metrology process, a semiconductor wafer is mechanically registered to the stage of a thickness measuring instrument. This instrument generates a map that indicates the thickness of an outer material layer of the wafer over an entire surface of the wafer. The outer layer thickness map generated from this metrology process is often used in other processes that thin or etch the material of the outer layer of the wafer to a desired thickness or in a desired location, respectively. These outer layer thinning and etching processes both include some type of tool that is directed onto the surface of the wafer. This tool must be properly positioned along the wafer surface to ensure that the thinning or etching process is performed at the correct location on the wafer surface. To ensure this proper wafer registration, an accurate correlation between the outer layer thickness map and the position of the wafer with respect to the thinning or etching tool is required.

For semiconductor wafers having flats, a current approach for correlating an outer layer thickness map with the position of the wafer in a thinning or etching instrument begins by marking the wafer with a set of alignment fiducials during the metrology process. The wafer is then placed on a larger diameter wafer which serves as a surround. The surround is made of the same material as the wafer undergoing work to maintain a consistent reaction in the thinning or etching process along the wafer edge. The flat of the fiducialized wafer is abutted to a flat registration surface of like wafer material that is taped to the surface of the surround, thereby registering the wafer in one direction. The wafer metrology fiducials are then visually aligned with a corresponding set of scribe marks on an aluminum holding plate, or platen, of the instrument. Once aligned, two additional registration surfaces of like wafer material are abutted against the wafer and taped to the surround to maintain the wafer position. The surround is then taped to the platen so that the thinning or etching process may begin. An apparatus for achieving such a registration of semiconductor wafers having flats is disclosed in US-A-5 180 150.

It is easily seen that the above-described correlated registration procedure can be time consuming and prone to human error. Furthermore, the above-described procedure does not allow for the correlated registration of notched semiconductor wafers. It is therefore desirable to provide a correlated registration apparatus and procedure that is less time consuming and less prone to human error than the above-described procedure, and that allows correlated registration of notched semiconductor wafers.

Such a desirable correlation registration procedure is achievable with an apparatus, described more thoroughly hereinafter in the detailed description, that is presently used to provide consistent registration of notched semiconductor wafers in metrology and thinning and etching instruments. A disadvantage of this presently used apparatus, however, is that jamming can occur due to friction between the surfaces of the wafer to be registered and the registration surfaces of the apparatus. Thus, it is further desirable to prevent such jamming in this presently used apparatus.

In US-A-4 887 904, an apparatus is disclosed for providing registration of semiconductor wafers undergoing process work in a plurality of process instruments, wherein each said semiconductor wafer undergoing work has a notch formed along a portion of its circumference. This known apparatus comprises means for supporting a notched semiconductor wafer to be registered, means for providing registration that accommodates the notch of the semiconductor wafer in the form of a pin which is slidably mounted on the support means, and first and second means for providing a registration that movably accommodates a first and a second point along the circumference of the notched semiconductor wafer in the form of rollers whose axes are slidably mounted on the support means.

### SUMMARY OF THE INVENTION

The present invention as defined in claim 1 contemplates an apparatus that provides consistent registration of notched semiconductor wafers and provides correlation between thinning and etching processes and metrology process data. Such an apparatus is comprised of a metal mounting plate upon which a notched wafer undergoing work lays flat. The wafer is partially registered to the metal plate by two rollers that are fixedly mounted to the plate. The first of these fixedly mounted rollers is positioned on the metal plate such that, when the wafer is properly registered, both walls of the wafer notch are abutted against this roller. The second of these fixedly mounted rollers is positioned on the metal plate such that the wafer, when properly registered, is abutted against this roller at a point on the wafer approximately -120° from the wafer notch. Proper registration is ensured by a third, adjustable roller that is fixedly mounted on a moveable metal bracket which allows the roller to move in an approximately radial direction with respect to the wafer. This third, adjustable roller applies a force against the wafer, at a point on the wafer approximately 120° from the wafer notch, by way of an external force applied to the moveable metal bracket. This force, coupled with the rolling capability of the rollers, ensures that an initially improperly registered wafer will be rotated into the proper registration position. Also, due to the fact that the rollers, by virtue of having rolling element bearings, generally exhibit only a slight amount of friction, or a rolling friction, the effective coefficient of friction between the rollers and the wafer is significantly less than a critical value in the effective coefficient of friction above which wafer jamming occurs. Thus, the wafer will be properly registered without jamming.

It should be noted that unlike the prior art, where the registration surfaces and the surround are fabricated from the same material as the wafer undergoing work, the rollers and associated mounting plate of the present invention are not subject to this same material constraint. As previously described, this constraint is required in the prior art so that consistent thinning and etching processes are maintained along the wafer edge. Although this material constraint does fulfill the object of maintaining consistent processes, a undesirable result of increased material replacement occurs since the thinning and etching processes depreciatively affect the registration and surround materials.

The material constraint and resulting material replacement problems of the prior art are overcome in the present invention by shielding the rollers and the associated mounting plate from the depreciative affects of the thinning and etching processes. Thus, the materials used in the present invention apparatus can be selected with practical considerations such a cost and reliability in mind, instead of impractical and costly material constraints.

The present invention apparatus described above can be used in thinning, etching, and metrology processes, among others, and provides consistent non-jamming registration of notched semiconductor wafers undergoing process work regardless of diameter variations among processed wafers. Furthermore, the use of this apparatus can decrease the registration time associated with the tedious visual alignment procedures of the prior art, while minimizing the potential for human error.

Accordingly, the primary object of the present invention is to provide an apparatus that provides consistent, non-jamming registration of notched semiconductor wafers.

Another object of the present invention is to provide an apparatus that can accurately correlate metrology process data to wafer registration in thinning and etching process instruments.

Another object of the present invention is to provide an apparatus that decreases wafer registration time as compared to prior art registration procedures.

Other object and advantages of the present invention will become apparent to those skilled in the art from the following detailed description of the invention read in conjunction with the appended claims and the drawings attached hereto.

### BRIEF DESCRIPTION OF THE DRAWINGS

In order to facilitate a fuller understanding of the present invention, reference is now made to the drawings. These drawings, are not drawn to scale and should not be construed as limiting the present invention, but are intended to be exemplary only.

Figure 1 is a plan view of a prior art notched semiconductor wafer registration apparatus that is experiencing wafer jamming.

Figure 2 is plan view of a notched semiconductor wafer registration apparatus embodying the principles of the present invention wherein rollers are used to consistently register notched semiconductor wafers.

### DETAILED DESCRIPTION OF THE INVENTION

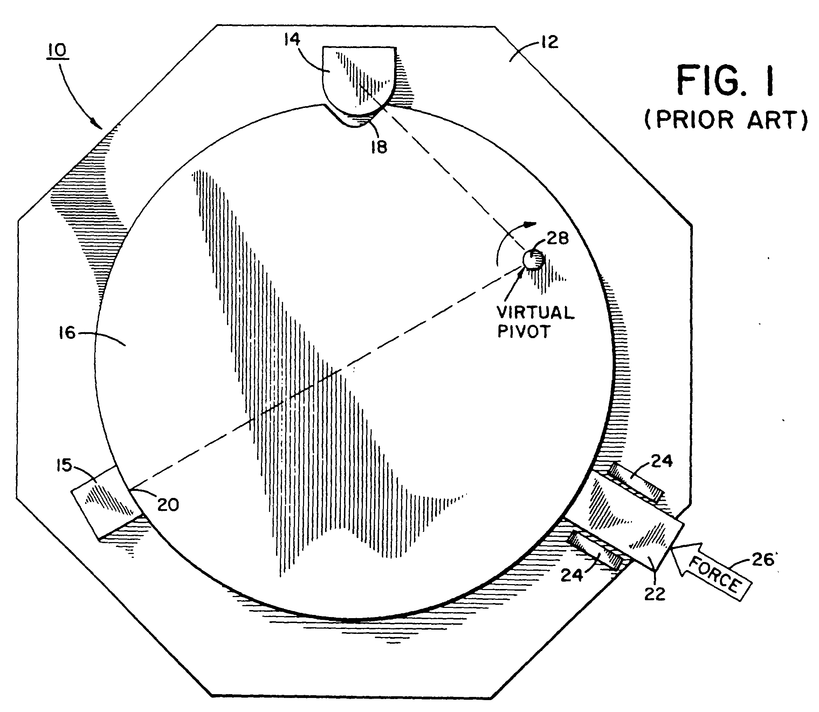

Referring to Figure 1, there is shown a prior art notched semiconductor wafer registration apparatus **10**, the use of which can result in wafer-jamming. This prior art apparatus **10** maintains a surround **12** upon which two registration surfaces **14**, **15** and two guides **24** are fixedly mounted. The first **14** of the two **14,15** fixedly mounted registration surfaces is used for registering a notch **18** of a wafer **16**. The second **15** of the two **14, 15** fixedly mounted registration surfaces is positioned to register a point **20** on the wafer **16** approximately -120° from the wafer notch **18**.

A third, adjustable registration surface **22** is placed between the two fixedly mounted guides **24**. In order to securely constrain the wafer **16** a force **26** is applied to this third, adjustable registration surface **22**, and hence to the wafer **16**. This force **26** tends to rotate the wafer **16** about a virtual pivot **28** until contact is made with all of the registration surfaces **14,15,22**. However, friction at the points of contact between the wafer **16** and the registration surfaces **14,15,22** tends to impede this necessary rotation. In fact, a critical value in the effective coefficient of friction between the wafer **16** and the registration surfaces **14,15,22** exists above which the necessary rotation does not occur regardless of the magnitude of the applied force **26**. This results in a friction jam that causes the wafer **16** to be improperly registered as shown.

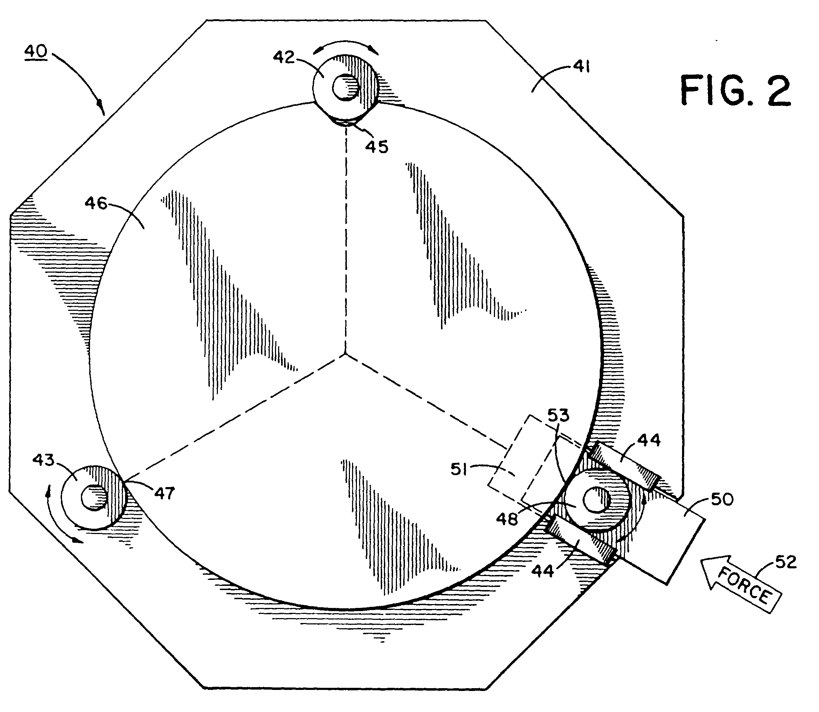

Referring to Figure 2, there is shown a notched semiconductor wafer registration apparatus **40** according to the present invention that overcomes the previously mentioned friction-jamming problems of the prior art. This apparatus **40** maintains an aluminum plate **41** upon which two rollers **42,43**, and two guides **44** are fixedly mounted. The aluminum plate **41** also provides an area upon which a semiconductor wafer **46** can be laid flat. The first **42** of the two **42,43** fixedly mounted rollers is positioned on the plate **41** such that, when the wafer **46** is properly registered, both walls of the wafer notch **45** are abutted against this roller **42**. The second **43** fixedly mounted roller is positioned on the plate **41** such that the wafer **46**, when properly registered, is abuttted against this roller **43** at a point **47** on the wafer **46** approximately -120° from the wafer notch **45**.

A third, adjustable roller **48** is fixedly mounted to a sliding aluminum bracket **50** that is positioned between the two guides **44** and within a radial groove **51** that has been fabricated or milled into the aluminum plate **41**. As should be apparent from the figure to one with ordinary skill in the art, the purpose of the two guides **44** and the radial groove **51** is to restrict the sliding aluminum bracket **50**, and hence the third roller **48**, to an approximately radial movement with respect to the wafer **46**. Alternatively, the sliding aluminum bracket **50** can be replaced b a pivot arm adapted to pivot about a pivot pin mounted to the plate **41**.

To ensure proper wafer registration, a external force **52** is applied to the sliding aluminum bracket **50**. This externally applied force **52** results in the third roller **48** applying a similar force against the wafer **46** at a point **53** on the wafer approximately 120° from the wafer notch **45**. This resulting force, coupled with the rolling capability of the rollers **42, 43, 48**, ensures that an improperly registered wafer will be rotated into the proper registration position, a shown. Also, due to the fact that the rollers **42, 43, 48,** by virtue of having rolling element bearings, generally exhibit only a slight amount of friction, or a rolling friction, the effective coefficient of friction between the rollers **42**, **43, 48** and the wafer **46** is significantly less than the critical value in the effective coefficient of friction above which wafer jamming occurs. Thus, the wafer **46** will be properly registered without jamming. Of course, proper registration will only occur when the wafer **46** is originally positioned on the plate **41** in a manner that will allow such registration; i.e. the wafer notch **45** must be in sufficiently close proximity to the first roller **42**. The present state of the art in wafer handling systems is such that this original positioning condition should be easily achieved.

It should be noted that although the apparatus **40** has been described herein with aluminum being the material of the plate **41** and the other associated components, other practical materials may also be used.

## Claims

1. An apparatus for providing consistent, non-jamming registration of semiconductor wafers (46) undergoing process work in a plurality of process instruments, wherein each said semiconductor wafer (46) undergoing work has a notch (45) formed along a portion of its circumference, said apparatus comprising:
means (41) for supporting a notched semiconductor wafer as to be registered;
means for providing a registration to the notch (45) of said notched semiconductor wafer (46);
first point registration means (43) comprising a first roller (43) rotatably mounted on an axis for providing a registration that movably accommodates a first point (47) along the circumference of said notched semiconductor wafer (46); and
second point registration means (44, 48, 50) comprising a second roller (48) being adjustable and rotatably mounted on an axis for providing a registration that movably accommodates a second point (53) along the circumference of said notched semiconductor wafer (46),
such that said first roller (43) and said second roller (48) movably accommodate said notched semiconductor wafer (46) via a force that is applied to said notched semiconductor wafer (46) by said second point registration means (44, 48, 50) as a result of an external force (52) that is applied to said second point registration means (44, 48, 50); **characterized in that**
said notch registration means comprises a third roller (42) rotatably mounted on an axis,
the axes of said first (43) and third (42) rollers are fixedly mounted to said support means (41),
said third roller (42) movably accommodates said notch (45) of said semiconductor wafer (46) by having both walls of said notch (45) abut against said third roller (42),
said first roller (43) movably accommodates said first point (47) by having said notched semiconductor wafer (46) abut against said first roller (43), and
said first, second and third rollers (43, 48, 42), allowing said notched semiconductor wafer (46) to rotate into a proper registration position.

2. The apparatus as defined in claim 1, wherein said supporting means (41) comprises a plate having a surface upon which said notched semiconductor wafer (46) is laid flat.

3. The apparatus as defined in claim 2, wherein said plate (41) includes an approximately radial groove (51) that assists in directing said applied force (52) approximately along the radius of said notched semiconductor wafer (46).

4. The apparatus as defined in claim 3, wherein said plate (41) is made of aluminum to withstand depreciative effects associated with said plurality of process instruments.

5. The apparatus as defined in claim 1, wherein said first point (47) along the circumference of said notched semiconductor wafer (46) is approximately -120° from said wafer notch (45).

6. The apparatus as defined in claim 1, wherein the axis of said second roller (48) is fixedly mounted to a bracket (50) that is movable approximately along the radius of said notched semiconductor wafer (46) such that the force applied against said notched semiconductor wafer (46) by said second roller (48) is approximately a radial force.

7. The apparatus as defined in claim 6, further comprising two guides (44), wherein said two guides (44) are fixedly mounted to said support means (41), and wherein said two guides (44) restrict said bracket (50) to said approximate radial movement.

8. The apparatus as defined in claim 7, wherein said bracket (50) and said guides (44) are made of aluminum to withstand depreciative effects associated with said plurality of process instruments.

9. The apparatus as defined in claim 8, wherein said second point (53) along the circumference of said notched semiconductor wafer is approximately 120° from said wafer notch (45).

## Patentansprüche

1. Vorrichtung zum Bereitstellen einer eindeutigen nichtblockierenden Registrierung von Halbleiterwafern (46), welche in einer Vielzahl an Bearbeitungsgeräten einer Bearbeitung unterliegen, wobei jeder der einer Bearbeitung unterliegenden Halbleiterwafer (46) eine Kerbe (45) besitzt, welche im Verlauf eines Bereiches seines Umfanges ausgebildet ist, wobei die Vorrichtung folgendes umfaßt:
Mittel (41) zum Tragen eines zu registrierenden gekerbten Halbleiterwafers;
Mittel zum Bereitstellen einer Registrierung der Kerbe (45) des gekerbten Halbleiterwafers (46);
ein erstes Punkterkennungsmittel (43), welches eine erste drehbar auf einer Achse montierte Rolle (43) zum Bereitstellen einer Registrierung umfaßt, welche sich beweglich einem ersten Punkt (47) entlang des Umfangs des gekerbten Halbleiterwafers (46) anpaßt; und
ein zweites Punkterkennungsmittel (44, 48, 50), welches eine zweite einstellbare und drehbar auf einer Achse montierte Rolle (48) zum Bereitstellen einer Registrierung umfaßt, welche sich beweglich einem zweiten Punkt (53) entlang des Umfangs des gekerbten Halbleiterwafers (46) anpaßt,
derart, daß die erste Rolle (43) und die zweite Rolle (48) sich beweglich dem gekerbten Halbleiterwafer (46) anpassen, über eine durch das zweite Punkterkennungsmittel (44, 48, 50) auf den gekerbten Halbleiterwafer (46) ausgeübte Kraft, als ein Ergebnis einer externen Kraft (52), welche auf das zweite Punkterkennungsmittel (44, 48, 50) ausgeübt wird; dadurch gekennzeichnet, daß
das Kerbenregistriermittel eine drehbar auf einer Achse montierte dritte Rolle (42) umfaßt,
die Achsen der ersten (43) und dritten (42) Rolle fest auf dem Trägermittel (41) montiert sind,
die dritte Rolle (42) sich beweglich der Kerbe (45) des Halbleiterwafers (46) anpaßt, wobei beide Wände der Kerbe (45) an die dritte Rolle (42) angrenzen,
die erste Rolle (43) sich beweglich dem ersten Punkt (47) anpaßt, wobei der gekerbte Halbleiterwafer (46) an die erste Rolle (43) angrenzt, und
die erste, zweite und dritte Rolle (43, 42, 48) es dem gekerbten Halbleiterwafer (46) ermöglichen, sich in eine geeignete Registrierposition zu drehen.

2. Vorrichtung gemäß Anspruch 1, wobei das Trägermittel (41) eine Platte mit einer Oberfläche umfaßt, auf welcher der gekerbte Halbleiterwafer (46) flach aufliegt.

3. Vorrichtung gemäß Anspruch 2, wobei die Platte (41) eine ungefähr radiale Rille (51) einschließt, welche bei der Ausrichtung der ungefähr entlang des Radius des gekerbten Halbleiterwafers (46) ausgeübten Kraft (52) hilft.

4. Vorrichtung gemäß Anspruch 3, wobei die Platte (41) aus Aluminium hergestellt ist, um verschlechternden Auswirkungen im Zusammenhang mit der Vielzahl an Bearbeitungsgeräten zu widerstehen.

5. Vorrichtung gemäß Anspruch 1, wobei der erste Punkt entlang des Umfanges des gekerbten Halbleiterwafers (46) ungefähr -120° von der Waferkerbe (45) entfernt ist.

6. Vorrichtung gemäß Anspruch 1, wobei die Achse der zweiten Rolle (48) fest auf einem Ausleger (50) montiert ist, welcher derart ungefähr in Richtung des Radius des gekerbten Halbleiterwafers (46) beweglich ist, daß die durch die zweite Rolle (48) auf den gekerbten Halbleiterwafer (46) ausgeübte Kraft ungefähr eine Radialkraft darstellt.

7. Vorrichtung gemäß Anspruch 6, welche ferner zwei Führungselemente (44) umfaßt, wobei die beiden Führungselemente (44) fest auf dem Trägermittel (41) montiert sind, und wobei die beiden Führungselemente (44) den Ausleger (50) auf die ungefähr radiale Bewegung beschränken.

8. Vorrichtung gemäß Anspruch 7, wobei der Ausleger (50) und die Führungselemente (44) aus Aluminium gefertigt sind, um verschlechternden Auswirkungen im Zusammenhang mit der Vielzahl an Bearbeitungsgeräten zu widerstehen.

9. Vorrichtung gemäß Anspruch 8, wobei der zweite Punkt (53) entlang des Umfanges des gekerbten Halbleiterwafers ungefähr 120° von der Waferkerbe (45) entfernt ist.

## Revendications

1. Appareil pour la mise en coïncidence reproductible et sans coincement de tranches (46) à semiconducteurs subissant un travail de traitement dans plusieurs instruments de traitement, dans lequel chacune desdites tranches (46) à semiconducteurs subissant un travail présente une encoche (45) formée le long d'une partie de sa circonférence, ledit appareil comportant :
des moyens (41) destinés à supporter une tranche encochée à semiconducteurs devant être mise en coïncidence ;
des moyens destinés à réaliser une mise en coïncidence avec l'encoche (45) de ladite tranche encochée (46) à semiconducteurs ;
des moyens (43) de mise en coïncidence d'un premier point comportant un premier galet (43) monté de façon à pouvoir tourner sur un axe pour établir une mise en coïncidence qui reçoit de façon mobile un premier point (47) le long de la circonférence de ladite tranche encochée (46) à semiconducteurs ; et
des moyens (44, 48, 50) de mise en coïncidence d'un second point comportant un deuxième galet (48) qui est réglable et qui est monté de façon à pouvoir tourner sur un axe pour réaliser une mise en coïncidence qui reçoit de façon mobile un second point (53) le long de la circonférence de ladite tranche encochée (46) à semiconducteurs,
de manière que ledit premier galet (43) et ledit deuxième galet (48) reçoivent de façon mobile ladite tranche encochée (46) à semiconducteurs par l'intermédiaire d'une force qui est appliquée à ladite tranche encochée (46) à semiconducteurs par lesdits moyens (44, 48, 50) de mise en coïncidence du second point, en conséquence d'une force extérieure (52) qui est appliquée auxdits moyens (44, 48, 50) de mise en coïncidence du second point ; caractérisé en ce que
lesdits moyens de mise en coïncidence de l'encoche comprennent un troisième galet (42) monté de façon à pouvoir tourner sur un axe,
les axes desdits premier (43) et troisième (42) galets sont montés fixement sur lesdits moyens de support (41),
ledit troisième galet (42) reçoit de façon mobile ladite encoche (45) de ladite tranche (46) à semiconducteurs par l'application en butée des deux parois de ladite encoche (45) contre ledit troisième galet (42),
ledit premier galet (43) reçoit de façon mobile ledit premier point (47) par l'application en butée de ladite tranche encochée (46) à semiconducteurs contre ledit premier galet (43), et
lesdits premier, deuxième et troisième galets (43, 48, 42) permettent à ladite tranche encochée (46) à semiconducteurs de tourner jusque dans une position de mise en coïncidence appropriée.

2. Appareil selon la revendication 1, dans lequel lesdits moyens (41) de support comprennent une plaque présentant une surface sur laquelle ladite tranche encochée (46) à semiconducteurs est posée à plat.

3. Appareil selon la revendication 2, dans lequel ladite plaque (41) présente une gorge approximativement radiale (51) qui aide à diriger ladite force appliquée (52) approximativement le long du rayon de ladite tranche encochée (46) à semiconducteurs.

4. Appareil selon la revendication 3, dans lequel ladite plaque (41) est réalisée en aluminium pour supporter les effets de dégradation associés auxdits instruments de traitement.

5. Appareil selon la revendication 1, dans lequel ledit premier point (47) le long de la circonférence de ladite tranche encochée (46) à semiconducteurs est situé à environ -120° de ladite encoche (45) de la tranche.

6. Appareil selon la revendication 1, dans lequel l'axe dudit deuxième galet (48) est monté fixement sur une console (50) qui est mobile approximativement le long du rayon de ladite tranche encochée (46) à semiconducteurs de façon que la force appliquée contre ladite tranche encochée (46) à semiconducteurs par ledit deuxième galet (48) soit approximativement une force radiale.

7. Appareil selon la revendication 6, comportant en outre deux guides (44), dans lequel lesdits deux guides (44) sont montés fixement sur lesdits moyens de support (41), et dans lequel lesdits deux guides (44) limitent ladite console (50) audit mouvement approximativement radial.

8. Appareil selon la revendication 7, dans lequel ladite console (50) et lesdits guides (44) sont réalisés en aluminium de façon à supporter des effets de dégradation associés auxdits instruments de traitement.

9. Appareil selon la revendication 8, dans lequel ledit second point (53) le long de la circonférence de ladite tranche encochée à semiconducteurs est à environ 120° de ladite encoche (45) de la tranche.
